# FASCICULE DE BREVET EUROPEEN

(11) **EP 2 174 346 B1**
(45) Date de publication et mention de la délivrance du brevet: **08.12.2010**
(21) Numéro de dépôt: 08786871.7
(22) Date de dépôt: 05.08.2008
(51) Int. Cl.: H01L 21/762

(54) **PROCEDE DE REPORT D'UNE COUCHE SUR UN MATERIAU LIQUIDE**
VERFAHREN ZUR ÜBERTRAGUNG EINER SCHICHT AUF EIN FLÜSSIGES MATERIAL
METHOD OF TRANSFERRING A LAYER ONTO A LIQUID MATERIAL

(30) Priorité: 07.08.2007 FR 0756983
(43) Date de publication de la demande: 14.04.2010
(73) Titulaire: Commissariat à l'Énergie Atomique et aux Énergies Alternatives, 75015 Paris (FR)
(72) Inventeur: BORDEL, Damien, F-38000 Grenoble (FR); DI CIOCCIO, Léa, F-38330 Saint Ismier (FR)
(74) Mandataire: Ilgart, Jean-Christophe
(86) Numéro de dépôt international: PCT/EP2008/060261
(87) Numéro de publication internationale: WO 2009/019265

(56) Documents cités:
- EP-A- 0 441 270
- US-A1- 2003 213 950
- WU ET AL: "Applying liquid film protection method to solid-state bonding process of AA7075 aluminum alloys" JOURNAL OF MATERIALS PROCESSING TECHNOLOGY, ELSEVIER, AMSTERDAM, NL, vol. 140, no. 1-3, 22 septembre 2003 (2003-09-22), pages 700-704, XP005349135 ISSN: 0924-0136
- UTHARA SRINIVASAN ET AL: "Microstructure to Substrate Self-Assembly Using Capillary Forces" JOURNAL OF MICROELECTROMECHANICAL SYSTEMS, IEEE SERVICE CENTER, PISCATAWAY, NJ, US, vol. 10, no. 1, mars 2001 (2001-03), XP011034623 ISSN: 1057-7157
- KOSTRZEWA M ET AL: "Feasibility of III-V on-silicon strain relaxed substrates" JOURNAL OF CRYSTAL GROWTH, ELSEVIER, AMSTERDAM, NL, vol. 275, no. 1-2, 15 février 2005 (2005-02-15), pages 157-166, XP004823195 ISSN: 0022-0248
- KOSTRZEWA M ET AL: "Feasibility of strain relaxed InAsP and InGaAs compliant substrates" 2003 INTERNATIONAL CONFERENCE INDIUM PHOSPHIDE AND RELATED MATERIALS. CONFERENCE PROCEEDINGS. (IPRM). SANTA BARBARA, CA, MAY 12 - 16, 2003, INTERNATIONAL CONFERENCE ON INDIUM PHOSPHIDE AND RELATED MATERIALS, NEW YORK, NY : IEEE, US, 12 mai 2003 (2003-05-12), pages 437-440, XP010746758 ISBN: 0-7803-7704-4

## Description

### DOMAINE TECHNIQUE ET ART ANTERIEUR

Les composants microélectroniques et optoélectroniques sont maintenant réalisés à partir de combinaisons de matériaux monocristallins élaborés par des techniques d'épitaxie. Les techniques d'épitaxie modernes permettent de préparer et de combiner des matériaux de très grande pureté présentant des propriétés proches de leurs performances théoriques idéales.

Toutefois, un certain nombre de verrous technologiques subsistent entravant le plein développement de ces techniques. En effet, dans le cas des applications à l'optoélectronique, les alliages semi-conducteurs couvrent un très large domaine de composition et donc de longueurs d'ondes associées et d'applications. Cependant, le caractère monocristallin des substrats et l'utilisation des techniques d'épitaxie conduisent à des limitations intrinsèques contraignantes puisqu'il ne sera possible à priori de ne combiner que des matériaux présentant des paramètres de maille identiques ou très voisins. En fait, en fonction des substrats disponibles, seuls d'étroits domaines de composition peuvent être exploités.

Il existe des tentatives pour faire croître, par hétéroépitaxie, des alliages présentant un désaccord de maille sur substrat standard. Ces alliages sont alors contraints. Au delà d'une épaisseur dite critique (de quelque nm), l'énergie de contrainte provoque la relaxation plastique de la couche épitaxiée. Il en résulte l'apparition de défauts structuraux étendus (faible désaccord) ou une croissance par îlots (fort désaccord). Ce mode de relaxation conduit à une rugosification de la surface et à une détérioration des propriétés optiques et électroniques des matériaux.

Dans le document de Y. H. Lo et al., Appl. Phys. Lett. 59, 2311, 1991, il est proposé de réaliser une couche désaccordée en paramètre de maille. Il s'agit d'une couche contrainte d'épaisseur inférieure à l'épaisseur critique de relaxation plastique, qui est relaxée élastiquement pour éviter une génération de défauts. Sur cette couche relaxée peut alors être effectuée une reprise d'épitaxie concordante en paramètre de maille, sur de grandes épaisseurs, sans génération de défauts. Ce concept permet d'obtenir des couches de compositions différentes des compositions utilisées sur substrat standard.

Cette approche consiste à épitaxier une couche contrainte sur un substrat puis à relaxer cette couche pour permettre une reprise d'épitaxie sans génération de défauts structuraux. La relaxation peut avoir lieu avant ou pendant la reprise d'épitaxie.

Cette relaxation peut être obtenue par différents procédés comme l'utilisation d'un matériau visqueux ou la sous gravure.

Cette approche a été appliquée par Yin H. Yin et al., J. Appl. Phys. 91, 9716, 2002, avec l'utilisation d'un verre (BPSG), ainsi que par M. Kostrzewa et al. J. Cryst. Growth. 275, 157, 2005, avec l'utilisation d'une cire. Dans cette technique la structure est reportée sur un matériau visqueux. La couche contrainte, une fois libéré du substrat sur lequel elle a été épitaxiée, se relaxe grâce à la viscosité du substrat support, généralement en chauffant le matériau visqueux afin d'augmenter sa viscosité.

Cependant, dans ces techniques, la viscosité de la couche n'est pas assez importante pour obtenir une bonne relaxation. De fait, celle-ci a lieu par formation d'ondulation en surface, ce qui peut présenter des inconvénients majeurs. En fonction de l'amplitude et de la longueur d'onde des ondulations, elle peut conduire à une rugosification de surface de la couche épitaxiale en raison du champ de déformation non homogène qu'elle génère en surface du matériau. Les techniques utilisant le report sur matériau visqueux sont donc limitées.

La technique de sous gravure appliquée par Damlencourt et al., Appl. Phys. Lett., 75, 3638, 1999, consiste à réaliser une couche contrainte quasi libre tenue par des bras. La couche est libérée de son support par sous gravure d'une couche d'arrêt. La couche est alors libre de se relaxer avant de venir se coller sur le substrat initial. Cependant la tenue par des bras limite la relaxation et la sélectivité de la couche contrainte par rapport à la couche d'arrêt limite la dimension des membranes relaxées.

Le document EP-A-0 441 270 divulgue l'utilisation d'un agent oxydant qui est eliminé avant de réaliser l'adhesion entre deux substrats. Le rôle de cet agent est d'éviter la présence d'air à l'interface de collage.

Il est donc nécessaire de développer une nouvelle technique permettant la relaxation de couches, notamment de grandes dimensions, sans les limitations indiquées ci-dessus.

### EXPOSÉ DE L'INVENTION

Un procédé selon l'invention comporte :
- un report d'une couche, supportée par un substrat initial, sur une couche liquide préalablement déposée sur un support, par exemple une couche d'eau, l'épaisseur de la couche liquide étant telle que les seules forces d'adhésion entre le liquide et ladite couche sont les forces de capillarité et que la couche à reporter est dans un état de flottement sur cette couche liquide.
- une libération de ladite couche du substrat initial et,
- Puis une évacuation de la couche liquide pour permettre l'adhésion moléculaire de la couche avec le support.

L'invention met en oeuvre l'utilisation d'un support avec une couche liquide intermédiaire, de préférence à faible viscosité, entre ce support et la couche à reporter. Cette couche liquide est finalement évacuée, ce qui conduit à une adhésion moléculaire sur le support, après élimination du substrat initial, par exemple par amincissement chimique localisé ou attaque chimique localisée.

La localisation de l'attaque chimique peut être obtenue à l'aide d'une cavité, préalablement formée dans le substrat initial, du côté opposé au côté de ce substrat assemblé avec la couche à reporter. Cette cavité peut être délimitée par un ou des mur(s) ou une ou des paroi(s) réalisé(s) dans le substrat initial.

Lorsque la couche à reporter est une couche contrainte, l'étape de libération permet de relaxer les contraintes dans cette couche, dont l'épaisseur peut être inférieure ou supérieure à son épaisseur critique.

Selon encore un autre exemple la couche à reporter peut présenter une courbure, que l'étape de libération permet d'aplanir.

La couche à reporter peut être une couche épitaxiée ou collée sur le substrat initial ou sur une couche d'arrêt formée sur ce substrat initial.

La couche à reporter peut être gravée afin de libérer son pourtour du centre. Cette couche peut aussi être rendue hydrophile, en vue de son assemblage par adhésion moléculaire.

Le support sur lequel la couche est reportée peut être lui-même déformé.

L'invention concerne également un procédé d'épitaxie d'une deuxième couche de matériau sur une première couche, comportant :
- le report de ladite première couche, assemblée à un substrat initial, sur un support, selon un procédé de report selon l'invention,
- puis la croissance épitaxiale de la deuxième couche sur la première.

### BRÈVE DESCRIPTION DES DESSINS

- Les figures 1A à 1E illustrent un mode de réalisation d'un procédé selon l'invention,
- les figures 2A à 2F illustrent un autre mode de réalisation d'un procédé selon l'invention,
- les figures 3 à 5 illustrent d'autres configurations auxquelles un procédé selon l'invention est applicable.

### EXPOSÉ DÉTAILLÉ DE MODES DE RÉALISATION PARTICULIERS

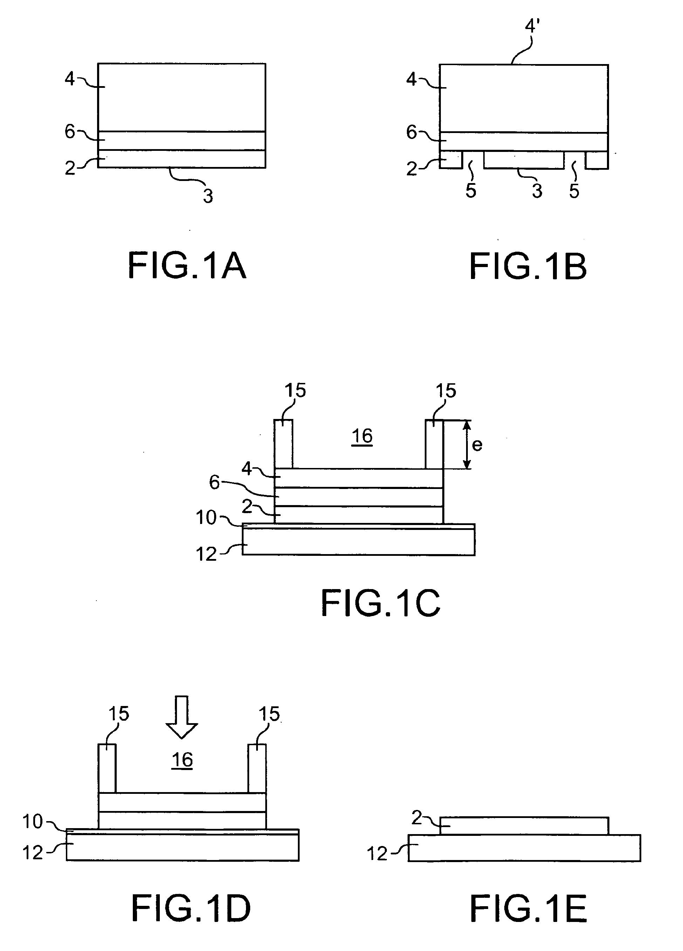

Un mode de réalisation de l'invention va d'abord être décrit en liaison avec les figures 1A-1E.

La figure 1A représente un substrat, dit substrat initial 4, sur lequel une couche 2 est formée ou déposée ou collée. Cette couche 2 est par exemple une couche épitaxiée.

Avantageusement la couche 2 est gravée afin de libérer son pourtour du centre (figure 1B). Les zones de gravure sont désignées par la référence 5. Ces zones n'apparaissent pas sur les figures 1C-1E, mais le mode de réalisation avec zones 5 de gravure se déduit de ces figures et des explications ci-dessous.

Entre cette couche 2 et le substrat initial peut être déposée ou formée une couche d'arrêt 6, qui aidera à contrôler la future libération de la couche 2. Cette couche 6 forme couche d'arrêt en vue d'une gravure chimique du matériau 4; une certaine sélectivité, de préférence au moins égale à 10, est souhaitée entre ces deux matériaux (la sélectivité étant le rapport entre la vitesse de gravure chimique du matériau de la couche 4 et le matériau de la couche 6). De préférence une certaine sélectivité, par exemple elle aussi au moins égale à 10, est également souhaitée entre la couche 6 et la couche 2, en vue de l'opération de retrait de la couche 6.

La surface 3 de la couche 2 est de préférence hydrophile ou rendue hydrophile, par exemple par traitement chimique ou polissage ou ajout de couche de type oxyde ou nitrure, en vue du collage moléculaire que l'on souhaite obtenir sur le support final 12 (figure 1E). Il en va de même de la surface de ce dernier.

La couche 2, avec le substrat initial 4, est déposée en contact avec une couche de matériau liquide 10, qui repose elle même sur le substrat 12 (figure 1C). On choisit l'épaisseur de cette couche liquide de sorte que les seules forces d'adhésion entre le liquide 10 et la couche 2 soient les forces de capillarité. Cette épaisseur est sensiblement celle permettant que les liaisons de Van der Waals n'interviennent plus pour relier la couche 2 au substrat 12 (contrairement au collage moléculaire hydrophile). Cette épaisseur est par exemple d'environ 10 nm. La couche 2 n'a, pendant cette étape, de préférence aucun contact direct avec le support 12.

On cherche ensuite à libérer la couche 2 du substrat initial 4. Avantageusement, cette libération est obtenue par gravure chimique de ce dernier. Pour ne pas perturber, par la gravure chimique, la couche 10 de matériau liquide, ou, plus généralement, l'environnement autour de la couche 2 et de son substrat 4, par exemple des composants voisins ou une structure voisine, des motifs ou des murs 15, qui délimitent une cavité 16, peuvent avoir été préalablement réalisés dans le substrat initial 4, afin de permettre une attaque chimique localisée sur l'ensemble du substrat 4 et de la couche 6, à l'exception de la périphérie (figure 1C).

Ces motifs 15, dans le substrat initial 4, peuvent être obtenus en amincissant mécaniquement celui-ci en son centre 4' sur une partie de son épaisseur (figure 1C), formant par là la cavité 16.

Le substrat 4 peut aussi être partiellement éliminé avant mise en contact de la couche 2 avec le liquide 10 ; puis, l'étape de libération proprement dite intervient, par gravure chimique, après mise en contact de la couche 2 avec le liquide 10. Le reste du substrat initial 4, et éventuellement de la couche d'arrêt 6, est donc gravé chimiquement, par exemple en confinant la solution chimique dans la cavité 16 (figure 1D).

La couche liquide 10 est avantageusement une couche contenant des molécules d'eau, le collage moléculaire s'obtient alors de façon naturelle après évacuation de ladite couche de liquide, entre le support 12 et la couche 2. Le collage moléculaire est alors un collage de type hydrophile.

L'évacuation de la couche liquide disposée entre la couche 2 et le support 12 est obtenue avantageusement par évaporation dudit liquide par exemple sous vide, ou par chauffage, ou encore par pompage (figure 1E).

Le retrait de la couche liquide permet de venir plaquer la couche 2 sur le support 12 à l'aide des forces de capillarité. Si le support 12 est déformé, et présente une courbure, ces forces permettent de mettre en contact la couche 2 avec ce support déformé. On verra plus loin qu'il est également possible de mettre en contact une couche 2, dont la surface est déformée et présente une courbure, avec un support 12 plan.

Les motifs ou murs résiduels 15 du substrat initial et de la couche contrainte peuvent être ensuite éliminés mécaniquement ou chimiquement (figure 1E). Il reste alors la couche 2, assemblée par adhérence moléculaire avec son support final 12.

Selon la technique exposée ci-dessus, la couche 2, initialement portée par le substrat initial 4, et éventuellement par une couche d'arrêt 6, est amenée sur la couche liquide 10 formée sur le support 12. La couche 2 est alors en état de flottement sur la couche liquide 10, sans contact physique direct avec le support 12. Le substrat initial peut ensuite être aminci (figures 1C et 1D). Après élimination de la couche liquide 10, par exemple par l'une des techniques déjà mentionnées ci-dessus, la couche 2 est en état d'adhésion moléculaire avec le support 12 (figure 1E).

Un autre exemple de réalisation de l'invention va être présenté pour le cas d'une couche 2 contrainte, par exemple une couche épitaxiée sur un substrat initial 4 de paramètre de maille différent de celui du matériau épitaxié. Ainsi on peut appliquer l'invention à tout matériau qui ne peut pas croître en homoépitaxie sans être dans un état de contrainte. Mais, comme déjà expliqué ci-dessus en liaison avec les figures 1A - 1E, l'invention s'applique à tout type de couche, donc également aux cas de couches qui ne sont pas dans un état de contrainte.

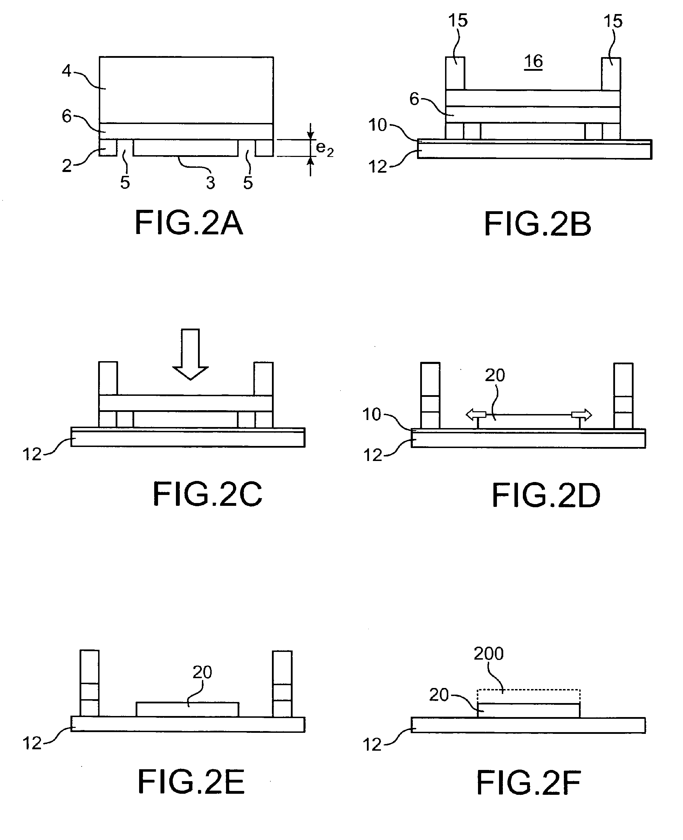

Dans cet exemple (figure 2A), l'épaisseur e2 de la couche 2 contrainte peut être inférieure à son épaisseur critique (épaisseur à partir de laquelle la contrainte va s'éliminer progressivement par déformation plastique), elle peut aussi être supérieure à cette épaisseur critique.

Comme déjà expliqué ci-dessus en liaison avec la figure 1B, avantageusement, la couche 2 est gravée afin de libérer son pourtour du centre (figure 2B et 2C). Les zones de gravure sont désignées par la référence 5. Cette gravure permet de libérer la zone à relaxer de la couche 2 par rapport aux bords. Les références 15 et 16 ont la même signification que sur les figures précédentes.

Là encore, une couche d'arrêt 6 joue le même rôle que dans l'exemple précédent, avec, de préférence, une certaine sélectivité, de préférence au moins égale à 10, entre les deux matériaux de la couche 4 et de la couche 6, pour la gravure chimique.

La surface 3 de la couche 2 est de préférence hydrophile ou rendue hydrophile, en vue du collage moléculaire que l'on souhaite obtenir sur le support final 12 (figure 2F). Il en va de même de la surface de ce dernier.

La couche 2 épitaxiée sur le substrat initial est déposée sur le matériau liquide 10 (figure 2B). Elle est alors en contact avec la couche liquide. L'épaisseur de cette couche liquide est telle que les seules forces d'adhésion entre le liquide 10 et la couche 2 soient les forces de capillarité. Autrement dit, la couche 2 n'a, pendant cette étape, aucun contact direct avec le support 12. On se référera aux indications déjà données ci-dessus pour ce qui concerne l'épaisseur de la couche de liquide.

La couche contrainte 2 est alors libre de se relaxer sur le matériau liquide (figure 2D), ce dernier étant confiné entre cette couche contrainte et le support 12. Une relaxation complète est atteinte lorsqu'il y a disparition des ondulations. Pour cela la couche liquide présente de préférence une faible viscosité. En d'autres termes, la couche visqueuse ne gène pas la relaxation par glissement de la couche 2. La viscosité à choisir dépend de la nature du matériau de la couche 2, de sa contrainte initiale et de la taille des échantillons à relaxer.

Le maintien de la couche contrainte 2 est assuré par les forces de capillarité qui l'empêchent de se déformer dans le plan vertical, par un effet d'enroulement.

La couche contrainte devient alors la couche relaxée 20.

L'évacuation de la couche liquide 10, disposée entre la couche relaxée 20 et le support 12, est obtenue par l'une des techniques déjà mentionnées ci-dessus en liaison avec les figures 1D et 1E.

Le retrait de la couche liquide permet de venir plaquer la couche relaxée 20 sur le support 12 à l'aide des forces de capillarité. Là encore, ces forces peuvent permettre de mettre en contact la couche relaxée 20 avec un support 12 déformé, présentant une courbure. On peut avantageusement appuyer pour chasser l'eau et forcer le collage après le collage sur le support 12.

Après évacuation de la couche liquide, on obtient un collage moléculaire entre la couche relaxée 20 et le support 12 (figure 2F).

La couche liquide 10 est avantageusement une couche contenant des molécules d'eau, le collage moléculaire s'obtient alors de façon naturelle après évacuation de ladite couche de liquide, entre le support 12 et la couche relaxée 20. Le collage moléculaire est alors un collage de type hydrophile. Les murs résiduels 15 du substrat initial et de la couche contrainte sont ensuite éliminés mécaniquement ou chimiquement (figure 2F).

On obtient ainsi une couche relaxée 20 reportée avantageusement sur un support 12, par exemple de type semi-conducteur (en silicium, ou en InP, etc...) ou autre.

L'invention s'applique également au cas d'une couche 2 à reporter dont la surface, à mettre en contact avec le substrat de report, présente une certaine courbure.

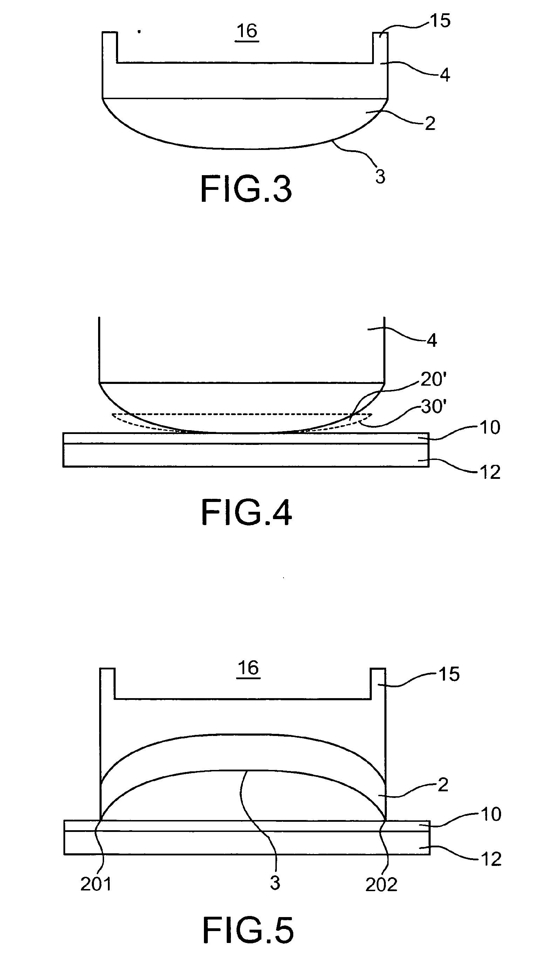

Par exemple, chacune des figures 3 et 5 représente un substrat ou une couche 2, dont la surface 3 est courbée (figures 3 et 4: surface 3 à courbure convexe; figure 5: surface 3 à courbure concave), et qui ne peut donc pas être collé directement sur un substrat à surface plane tel que le substrat 12 des figures 1C et 2B. Les courbures indiquées sur ces figures sont exagérées pour des raisons de clarté. Cette couche 2 est, comme dans les exemples précédents, assemblée ou collée avec un substrat initial 4, elle peut aussi résulter d'une épitaxie sur ce substrat, avec éventuellement des contraintes comme expliqué ci-dessus en liaison avec les figures 2A-2F. Dans le substrat 4 des figures 3-5, une cavité 16 a été gravée, avec des motifs 15 autour, pour les mêmes raisons que précédemment. Comme sur les figures précédentes, il peut y avoir une couche 6 d'arrêt (avec les mêmes fonctions et propriétés que celles indiquées précédemment) entre la couche 2 et le substrat 4, bien qu'elle ne soit pas représentée sur la figure 3 et des zones 5 peuvent être gravées dans la couche 2.

On positionne la couche 2 en contact avec une couche liquide 10 sur le support 12 (figure 4). On peut ensuite procéder à un amincissement, d'abord du substrat 4, puis éventuellement de la couche 2, comme expliqué en liaison avec les exemples précédents, au cours duquel la surface 30 va progressivement s'aplatir et se rapprocher de la surface du liquide 10, et les éventuelles contraintes de la couche 2 vont se relaxer. Ainsi, on a représenté sur la figure 4, en traits interrompus, la situation intermédiaire du substrat aminci, désigné par la référence 20', et de sa surface 30', moins courbée que la surface 30 initiale.

Lorsque l'amincissement est poursuivi, la surface 3 de la couche 2 est complètement ou presque complètement en contact avec la couche liquide 10. Comme déjà expliqué ci-dessus, celle-ci est ensuite évacuée et les deux surfaces hydrophiles (surface 3 et surface du support 12) sont assemblées par collage par adhésion moléculaire.

Dans le cas de la figure 5, la couche ou le substrat 2 présente une courbure de sa surface 30, inversée par rapport à la courbure de la surface 3 du substrat 2 de la figure 3.

Le positionnement du substrat 2 sur la couche liquide 10 permet d'empêcher le collage ou l'adhésion des points d'extrémité 201, 202 directement sur le substrat 12; une telle adhésion directe empêcherait toute relaxation de la couche 2. Par amincissement progressif de cette dernière, la surface 3 va venir progressivement en contact, complètement ou presque complètement, avec la couche liquide 10, ce contact étant là encore assuré par les forces de capillarité. Puis la couche 10 est évacuée et les deux surfaces hydrophiles sont assemblées par collage par adhésion moléculaire.

Dans tous les exemples donnés ci-dessus, le matériau de la couche 2 est par exemple un matériau semi-conducteur, notamment de type III-V. Un exemple d'un tel matériau est le GaN.

Dans les cas présentés ci-dessus, une reprise d'épitaxie peut ensuite être effectuée sur la couche 2. Autrement dit, on peut réaliser, après transfert de la première couche 2 ou 20 sur un support 12, selon l'une des techniques exposées ci-dessus, la croissance épitaxiale d'une deuxième couche de matériau sur cette première couche. Ainsi, la couche 200 de la figure 2F est formée par croissance épitaxiale sur la couche 20. En fait cette reprise d'épitaxie est plus ou moins aisée selon la différence des coefficients de dilatation thermique des matériaux.

Selon un exemple d'application, la couche contrainte 2 est composée d'In_{0.65}Ga_{0.35}As contraint à 0.8 %. Cette couche est épitaxié par MBE (épitaxie par jet moléculaire) sur un substrat 4 d'InP via des couches d'arrêts 6 d'In_{0.53}Ga_{0.47}As et d'InP. Des motifs 5 sont formés dans la couche contrainte par photolithographie.

Le dessus du substrat 4 est, à son tour, aminci chimiquement à l'aide d'une solution HCl : H₂O (3 :1) en protégeant les bords 15 par de la résine, de façon à ce que ceux-ci ne soient pas attaqués par la solution de gravure. La couche contrainte 2 est rendue hydrophile par exposition aux UV sous O₃ pendant 10 minutes.

Le substrat hôte 12 est un substrat de Si, ou autre ; éventuellement, une couche superficielle de SiO₂, de 400 nm d'épaisseur environ, recouvre le substrat 12. Ce dernier est rendu hydrophile par une exposition au plasma 02.

Une fine pellicule d'eau 10 est ensuite déposée en passant une chiffonette humide sur le substrat 12.

La structure est déposée sur le substrat de silicium. Les couches 4, 6 d'InP et d'InGaAs sont gravées respectivement à l'aide de solutions HCl:H₂O (à 3:1) et H₂SO₄ : H₂O₂ : H₂O (à 1:1:10). La couche contrainte 20 est alors libre de se relaxer élastiquement sur le film 10 d'eau.

Ce dernier est alors évaporé en laissant la structure à l'air ambiant, permettant à la couche relaxée 20 de venir en contact avec le substrat 12 de silicium, dont la surface a été préalablement rendue hydrophile. Le collage s'effectue par collage moléculaire. Un recuit de renforcement de collage est effectué à 200°C pendant 2 h.

Les bords de la structure sont retirés chimiquement avec les solutions décrites précédemment.

Une reprise d'épitaxie peut ensuite être effectuée sur la couche 2.

Selon un autre exemple d'application, l'invention a été mise en oeuvre avec succès sur des puces de 5 mm par 5 mm et de 10 mm par 3 mm avec un volume d'eau 10 compris entre 0.2 et 0.7 microlitres. Un tel volume d'eau permet en plus à la puce de s'autopositionner sur le substrat 12 avant son collage.

Comme expliqué ci-dessus en liaison avec les figures 1A-1E, l'invention ne s'applique pas seulement à une couche 2 contrainte. Elle peut s'appliquer en tant que technique de report d'une couche quelconque.

## Revendications

1. Procédé de report d'une couche (2) à reporter sur un support (12), comportant :
- le report de ladite couche, assemblée à un substrat initial (4), sur une couche liquide (10) préalablement déposée sur ledit support (12), l'épaisseur de la couche liquide étant telle que les seules forces d'adhésion entre le liquide et ladite couche sont les forces de capillarité et que la couche à reporter est dans un état de flottement sur cette couche liquide,
- la libération de ladite couche du substrat initial (4), par attaque chimique,
- puis l'évacuation de la couche liquide (10) pour permettre l'adhésion moléculaire de la couche sur le support (12).

2. Procédé selon la revendication 1, la couche (2) à reporter étant une couche contrainte, l'étape de libération permettant de relaxer les contraintes dans cette couche.

3. Procédé selon la revendication 2, l'épaisseur de la couche contrainte étant inférieure à son épaisseur critique.

4. Procédé selon l'une des revendications 1 à 3, la surface libre de la couche (2) à reporter présentant une courbure, que l'étape de libération permet d'aplanir.

5. Procédé selon l'une des revendications 1 à 4, la couche (2) à reporter étant une couche épitaxiée ou collée sur le substrat initial.

6. Procédé selon l'une des revendications 1 à 5, une couche d'arrêt (6) étant formée sur le substrat initial (4), la couche (2) à reporter étant assemblée avec le substrat initial par l'intermédiaire de cette couche d'arrêt.

7. Procédé selon l'une des revendications 1 à 6, la couche à reporter étant gravée afin de libérer son pourtour du centre.

8. Procédé selon l'une des revendications 1 à 7, la couche (2) à reporter étant rendue hydrophile, avant report sur la couche liquide (10).

9. Procédé selon l'une des revendications 1 à 8, la libération de la couche (2) à reporter, du substrat initial (4), étant obtenue par gravure chimique dudit substrat.

10. Procédé selon l'une des revendications 1 à 9, une cavité (16) étant préalablement formée dans le substrat initial (4), du côté opposé au côté de ce substrat assemblé avec la couche (2) à reporter, pour permettre une attaque chimique localisée sur l'ensemble dudit substrat initial (4), à l'exception de sa périphérie.

11. Procédé selon la revendication 10, le substrat initial, et éventuellement la couche d'arrêt (6), étant gravés chimiquement en confinant la solution chimique dans la cavité (16) préalablement formée.

12. Procédé selon l'une des revendications 1 à 11, l'évacuation de la couche liquide (10) disposée entre la couche (2) à reporter et le support final (12) étant obtenue par évaporation dudit liquide ou par pompage.

13. Procédé selon l'une des revendications 1 à 12, le support (12) étant déformé.

14. Procédé selon l'une des revendications 1 à 13, le matériau de la couche (2) à reporter étant en un matériau semi-conducteur, notamment de type III-V, par exemple en GaN.

15. Procédé d'épitaxie d'une deuxième couche (200) de matériau sur une première couche (2), comportant :
- le report de ladite première couche, assemblée à un substrat initial (4), sur un support (12), selon un procédé de report selon l'une des revendications 1 à 14,
- puis la croissance épitaxiale de la deuxième couche sur la première.

## Claims

1. Method for transferring a layer (2) to be transferred onto a support (12), comprising:
- the transfer of said layer, assembled on an initial substrate (4), onto a liquid layer (10) previously deposited on said support (12), the thickness of the liquid layer being such that the only adhesion forces between the liquid and said layer are capillarity forces and that the layer to be transferred is in a floating state on said liquid layer,
- the release of said layer from the initial substrate (4), by chemical attack,
- then the evacuation of the liquid layer (10) to allow the molecular adhesion of the layer to the support (12).

2. Method according to claim 1, the layer (2) to be transferred being a strained layer, the release step enabling the strains in this layer to be relaxed.

3. Method according to claim 2, the thickness of the strained layer being less than its critical thickness.

4. Method according to one of claims 1 to 3, the free surface of the layer (2) to be transferred having a curvature, which the release step makes it possible to flatten.

5. Method according to one of claims 1 to 4, the layer (2) to be transferred being a layer epitaxied or bonded onto the initial substrate.

6. Method according to one of claims 1 to 5, a stop layer (6) being formed on the initial substrate (4), the layer (2) to be transferred being assembled with the initial substrate through the intermediary of this stop layer.

7. Method according to one of claims 1 to 6, the layer to be transferred being etched in order to release its circumference from the centre.

8. Method according to one of claims 1 to 7, the layer (2) to be transferred being rendered hydrophilic, before transfer onto the liquid layer (10).

9. Method according to one of claims 1 to 8, the release of the layer (2) to be transferred, from the initial substrate (4), being obtained by chemical etching of said substrate.

10. Method according to one of claims 1 to 9, a cavity (16) being formed previously in the initial substrate (4), on the side opposite to the side of said substrate assembled with the layer (2) to be transferred, to allow a localised chemical attack on the whole of said initial substrate (4), with the exception of its periphery.

11. Method according to claim 10, the initial substrate, and if necessary the stop layer (6), being chemically etched by confining the chemical solution within the cavity (16) formed previously.

12. Method according to one of claims 1 to 11, the evacuation of the liquid layer (10) placed between the layer (2) to be transferred and the final support (12) being obtained by evaporation of said liquid or by pumping.

13. Method according to one of claims 1 to 12, the support (12) being deformed.

14. Method according to one of claims 1 to 13, the material of the layer (2) to be transferred being made of a semi-conductor material, particularly of III-V type, for example GaN.

15. Method for epitaxying a second layer (200) of material on a first layer (2), comprising:
- the transfer of said first layer, assembled on an initial substrate (4), onto a support (12), according to a transfer method according to one of claims 1 to 14,
- then the epitaxial growth of the second layer on the first.

## Patentansprüche

1. Verfahren zur Übertragung einer Schicht (2) auf einen Träger (12), umfassend:
- das Übertragen der genannten mit einem Ausgangssubstrat verbundenen Schicht (4) auf eine vorher auf den genannten Träger (12) aufgebrachte flüssige Schicht (10), wobei die Dicke der flüssigen Schicht so ist, dass die einzigen Adhäsionskräfte zwischen der Flüssigkeit und der genannten Schicht Kapillarkräfite sind und dass die zu übertragende Schicht in einem Zustand des Schwimmens auf dieser flüssigen Schicht ist,
- das Freimachen der genannten Schicht von dem Ausgangssubstrat (4) durch chemischen Angriff,
- dann das Eliminieren der flüssigen Schicht (10), um die Molekularadhäsion der Schicht auf dem Träger (12) zu ermöglichen.

2. Verfahren nach Anspruch 1, wobei der Freimachungsschritt im Falle einer gespannten zu übertragenden Schicht (2) ermöglicht, die Spannungen in dieser Schicht zu eliminieren.

3. Verfahren nach Anspruch 2, wobei die Dicke der gespannten Schicht kleiner ist als ihre kritische Dicke.

4. Verfahren nach einem der Ansprüche 1 bis 3, wobei die freie Oberfläche der zu übertragenden Schicht (2) eine Krümmung aufweist, die zu glätten der Freimachungsschritt ermöglicht.

5. Verfahren nach einem der Ansprüche 1 bis 4, wobei die zu übertragende Schicht (2) eine auf das Ausgangssubstrat epitaxierte oder geklebte Schicht ist.

6. Verfahren nach einem der Ansprüche 1 bis 5, wobei auf dem Ausgangssubstrat (4) eine Sperrschicht (6) ausgebildet wird und die zu übertragende Schicht (2) mit dem Ausgangssubstrat mittels dieser Sperrschicht zusammengefügt wird.

7. Verfahren nach einem der Ansprüche 1 bis 6, wobei die zu übertragende Schicht geätzt wird, um ihre Umrandung von der Mitte frei zu machen.

8. Verfahren nach einem der Ansprüche 1 bis 7 wobei die zu übertragende Schicht (2) vor der Übertragung auf die flüssige Schicht (10) hydrophil gemacht wird.

9. Verfahren nach einem der Ansprüche 1 bis 8, wobei die Befreiung der zu übertragenden Schicht (2) von dem Ausgangssubstrat (4) durch chemische Ätzung des genannten Substrats realisiert wird.

10. Verfahren nach einem der Ansprüche 1 bis 9, wobei im Voraus in dem Ausgangssubstrat (4) ein Hohlraum (16) ausgebildet wird - auf der zu derjenigen Seite dieses Substrats entgegengesetzten Seite, die mit der zu übertragenden Schicht (2) zusammengefügt ist -, um einen lokalisierten chemischen Angriff auf das gesamte genannte Ausgangssubstrats (4) zu ermöglichen, mit Ausnahme seiner Peripherie.

11. Verfahren nach Anspruch 10, wobei das Ausgangssubstrat und eventuell die Sperrschicht (6) chemisch geätzt werden und dabei die chemische Lösung in dem vorher ausgebildeten Hohlraum (16) enthalten ist.

12. Verfahren nach einem der Ansprüche 1 bis 11, wobei die Eliminierung der zwischen der zu übertragenden Schicht (2) und dem Endträger (12) angeordneten flüssigen Schicht (10) durch Verdampfen der genannten Flüssigkeit oder durch Pumpen realisiert wird.

13. Verfahren nach einem der Ansprüche 1 bis 12, wobei der Träger (12) deformiert ist.

14. Verfahren nach einem der Ansprüche 1 bis 13, wobei das Material der zu übertragenden Schicht (2) ein Halbleitermaterial ist, insbesondere des Typs III-V, zum Beispiel GaN.

15. Epitaxieverfahren einer zweiten Materialschicht (200) auf eine erste Schicht (2), umfassend:
- die Übertragung der genannten ersten Schicht, zusammengefügt mit einem Ausgangssubstrat (4), auf einen Träger (12), nach einem Übertragungsverfahren nach einem der Ansprüche 1 bis 14,
- dann das epitaktische Aufwachsen der zweiten Schicht auf der ersten.
